# EUROPEAN PATENT APPLICATION

(11) **EP 2 407 984 A2**
(43) Date of publication of application: **18.01.2012**
(21) Application number: 10252176.2
(22) Date of filing: 21.12.2010
(51) Int. Cl.: H01G 9/20

(54) **Photoelectric conversion module**

(30) Priority: 12.07.2010 US 363588 P
(71) Applicant: Samsung SDI Co., Ltd., Yongin-si, Gyeonggi-do (KR)
(72) Inventor: Kim, Hyun-Chul , Samsung SDI Co.,Ltd, Yongin-si, Gyeonggi-do (KR); Hur, Sang-Yeol , Samsung SDI Co.,Ltd, Yongin-si, Gyeonggi-do (KR); Jung, Joo-Sik , Samsung SDI Co.,Ltd, Yongin-si, Gyeonggi-do (KR)
(74) Representative: Mounteney, Simon James

(57) **Abstract**

A photoelectric conversion device comprises a first substrate and a second substrate opposing the first substrate. The first photoelectric cell is located between the first and second substrates and contains electrolyte. The first photoelectric cell includes a first optical electrode over the first substrate and a first counter electrode over the second substrate. The first optical electrode comprises a first semiconductor layer and a second photoelectric cell located between the first and second substrates containing electrolyte. The second photoelectric cell is adjacent the first photoelectric cell and includes a second optical electrode over the second substrate and a second counter electrode over the first substrate. The second optical electrode comprises a second semiconductor layer. The size of the second semiconductor layer is larger than that of the first semiconductor layer.

## Description

The present invention relates to a photoelectric conversion module.

In general, photoelectric conversion modules convert optical energy into electric energy and may include, for example, solar cells using solar light.

General solar cells are wafer-type silicon or crystalline solar cells using a p-n junction of semiconductors. However, a high-purity semiconductor material may be used to form silicon solar cells and thus the manufacturing cost thereof is high.

Unlike silicon solar cells, dye-sensitized solar cells (DSSC) each include photosensitive dye, a semiconductor material, and an electrolyte, wherein the photosensitive dye generates excited electrons when visible light is incident thereon, the semiconductor material receives the excited electrons, and the electrolyte reacts with the electrons via an external circuit. A DSSC has significantly higher photoelectric conversion efficiency compared with that of a silicon solar cell and thus has recently been highlighted as a next generation solar cell.

The present invention sets out to provide a photoelectric conversion device having improved electricity generation efficiency relative to the prior art.

Accordingly the invention provides a photoelectric conversion device as set out in Claim 1. Preferred features of the invention are set out in Claims 2 to 15.

Embodiments of the invention will be further described with reference to the accompanying drawings in which:
FIG. 1 is a cross-sectional view of a photoelectric conversion module according to an embodiment of the present invention;
FIG. 2A is a plan view of a light receiving substrate of the photoelectric conversion module of FIG. 1;
FIG. 2B is a plan view of a counter substrate of the photoelectric conversion module of FIG. 1;
FIG. 3 is a graph showing electricity generation efficiency of the photoelectric conversion module of FIG. 1; and
FIG. 4 is a cross-sectional view of a photoelectric conversion module according to another embodiment of the present invention.

Reference will now be made in detail to embodiments of the invention, examples of which are illustrated in the accompanying drawings, wherein like reference numerals refer to the like elements throughout.

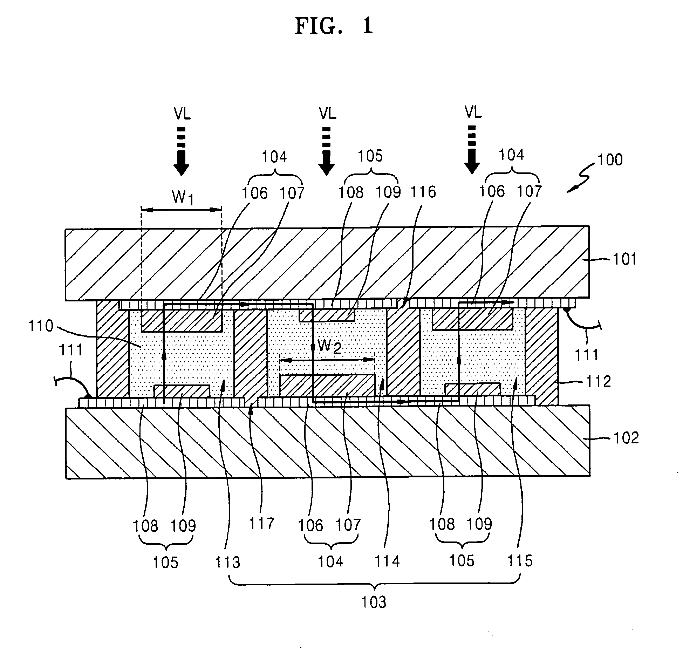

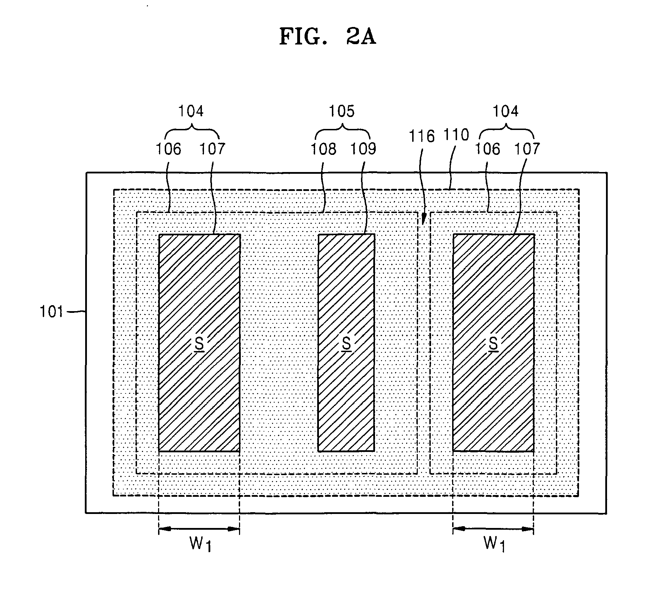

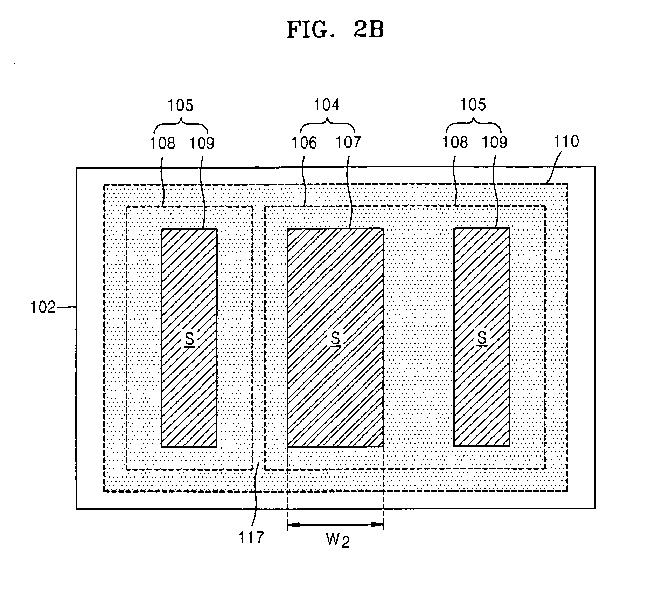

FIG. 1 is a cross-sectional view of a photoelectric conversion module 100 according to an embodiment of the present invention, FIG. 2A is a plan view of a light receiving substrate 101 of the photoelectric conversion module 100, and FIG. 2B is a plan view of a counter substrate 102 of the photoelectric conversion module 100.

Referring to FIGS. 1, 2A, and 2B, the light receiving substrate 101 and the counter substrate 102 face each other.

The light receiving substrate 101 may be formed of a transparent material, for example, a material having high light transmittance. For example, the light receiving substrate 101 may be formed of glass or a resin film. A resin film is flexible and thus may be appropriate for devices that require flexibility.

The counter substrate 102 does not particularly require transparency. However, the counter substrate 102 may be formed of a transparent material to receive light VL from both sides of the photoelectric conversion module 100 so as to increase the photoelectric conversion efficiency. For example, the counter substrate 102 may be formed of the same material as the light receiving substrate 101.

In particular, if the photoelectric conversion module 100 is used as a building integrated photovoltaic system (BIPV) installed to a structure such as a window frame of a building, both sides of the photoelectric conversion module 100 may be transparent in order to not block light from flowing into the building.

A plurality of unit photoelectric cells 103 are formed in an inner space between the light receiving substrate 101 and the counter substrate 102. The unit photoelectric cells 103 include optical electrodes 104 and counter electrodes 105 for performing photoelectric conversion.

The optical electrodes 104 each include a first transparent conductive film 106 and a semiconductor layer 107. The counter electrodes 105 each include a second transparent conductive film 108 and a catalyst layer 109. Electrolyte layers 110 are interposed between the optical electrodes 104 and the counter electrodes 105. The first transparent conductive films 106 and the second transparent conductive films 108 are each connected to each other in series or in parallel by using leads 111. In the current embodiment, the first transparent conductive films 106 and the second transparent conductive films 108 are each connected to each other in series.

The first transparent conductive films 106 are disposed on the inner surface of the light receiving substrate 101. The first transparent conductive films 106 may be formed of a transparent and electrically conductive material. For example, the first transparent conductive films 106 may include a transparent conducting oxide (TCO) such as an indium tin oxide (ITO), a fluorine tin oxide (FTO), or an antimony-doped tin oxide (ATO).

Although not illustrated, a first grid pattern may be further formed on the first transparent conductive films 106. The first grid pattern may be formed to lower electric resistance of the first transparent conductive films 106. The first grid pattern is a wiring that collects electrons generated according to a photoelectric conversion operation and provides a low resistance current path. For example, the first grid pattern may be formed of a metal material having excellent electrical conductivity such as gold (Au), silver (Ag), or aluminum (Al). The first grid pattern may be formed in any of various patterns such as a solid pattern having a specific shape such as square or a meshed pattern having a predetermined opening.

When the first grid pattern is formed, a first protection layer may be further formed to cover the first grid pattern. The first protection layer prevents contact between the first grid pattern and the electrolyte layer 110 and thus prevents electrodes from being damaged, for example, prevents corrosion of the first grid pattern. The first protection layer may be formed of a material that does not react with electrolytes, for example, curable resin.

The optical electrodes 104 function as negative electrodes of the photoelectric conversion module 100 and may have high aperture ratio. The light VL incident through the first transparent conductive films 106 functions as an excitation source of photosensitive dye adsorbed to the semiconductor layers 107. Accordingly, the photoelectric conversion efficiency may be improved by increasing an amount of the light VL.

The semiconductor layers 107 may be formed of a metal compound such as Cd, Zn, In, Pb, Mo, W, Sb, Ti, Ag, Mn, Sn, Zr, Sr, Ga, Si, or Cr. The semiconductor layers 107 adsorb photosensitive dye and thus may increase the photoelectric conversion efficiency.

For example, the semiconductor layers 107 may be formed by coating paste in which semiconductor particles having a diameter of about 5 to 1000 nm are dispersed on the light receiving substrate 101 on which the first transparent conductive films 106 are formed and then applying predetermined heat or pressure to the paste.

The semiconductor layers 107 adsorb photosensitive dye that may be excited by the light VL. The photosensitive dye adsorbed to the semiconductor layers 107 absorbs the light VL penetrating the light receiving substrate 101 and incident on the photosensitive dye, and electrons of the photosensitive dye are excited into an excitation state from a ground state. The excited electrons are transited to a conduction band of the semiconductor layers 107 by using electrical junction between the photosensitive dye and the semiconductor layers 107 and then pass through the semiconductor layers 107 so as to reach the first transparent conductive films 106. Then, the excited electrons are withdrawn out of the photoelectric conversion module 100 through the first transparent conductive film 106 and thus may constitute a driving current for driving an external circuit.

For example, the photosensitive dye adsorbed to the semiconductor layers 107 includes molecules that absorb visible light in a visible ray band and cause rapid electron transfer to the semiconductor layers 107 when in a light excitation state. The photosensitive dye may be liquid, gel that is semisolid, or solid. For example, the photosensitive dye adsorbed to the semiconductor layers 107 may be ruthenium based photosensitive dye. The semiconductor layers 107, which adsorb the photosensitive dye, may be obtained by immersing the light receiving substrate 101 on which the semiconductor layers 107 are formed with a solution including a predetermined photosensitive dye.

The second transparent conductive films 108 are disposed on the inner surface of the counter substrate 102. The second transparent conductive films 108 may be formed of a transparent and electrically conductive material. For example, the second transparent conductive films 108 may include a TCO such as an ITO, a FTO, or an ATO. Although not illustrated, a second grid pattern and a second protection layer covering the second grid pattern may be further formed on the second transparent conductive films 108.

The counter electrodes 105 function as positive electrodes of the photoelectric conversion module 100 and as a reduction catalyst for providing electrons to the electrolyte layers 110. The photosensitive dye adsorbed to the semiconductor layers 107 may generate excited electrons by absorbing the light VL. The excited electrons are withdrawn out of the photoelectric conversion module 100 through the second transparent conductive films 108.

The photosensitive dye in which electrons thereof are removed is reduced again by collecting electrons provided by oxidization of the electrolyte layers 110 and the oxidized electrolyte layers 110 are reduced again by electrons reaching the second transparent conductive films 108 via an external circuit, thereby completing an operation of the photoelectric conversion module 100.

The catalyst layers 109 may be formed of a material that functions as a reduction catalyst for providing electrons to the electrolyte layers 110. For example, the catalyst layer 109 may be formed of a metal such as platinum (Pt), gold (Au), silver (Ag), copper (Cu), or aluminum (AI), a metal oxide such as tin oxide, or a carbon-based material such as graphite.

A Redox electrolyte including an oxidant and reductant pair may be applied to the electrolyte layers 110. For example, the electrolyte layers 110 may be any of a solid electrolyte, a gel-type electrolyte, and a liquid electrolyte.

The plurality of unit photoelectric cells 103 are arranged in between the light receiving substrate 101 and the counter substrate 102 by sealants 112. The sealants 112 seal the electrolyte layer 110 so as to prevent an electrolyte of the electrolyte layers 110 from leaking out of the photoelectric conversion module 100.

In the current embodiment, the unit photoelectric cells 103 include three unit photoelectric cells S, for example, a first unit photoelectric cell 113, a second unit photoelectric cell 114, and a third unit photoelectric cell 115. However, the number of unit photoelectric cells 103 may vary according to the design of the photoelectric conversion module 100.

Here, the optical electrodes 104 and the counter electrodes 105 are alternately arranged on the light receiving substrate 101. The counter electrodes 105 and the optical electrodes 104 are alternately arranged on the counter substrate 102. The counter electrodes 105 and the optical electrodes 104 alternately arranged on the counter substrate 102 face the optical electrodes 104 and the counter electrodes 105 alternately arranged on the light receiving substrate 101, respectively.

Also, transparent conductive films on the light receiving substrate 101 of two adjacent unit photoelectric cells 103, that is, the first transparent conductive film 106 on the light receiving substrate 101 of one unit photoelectric cell 103 and the second transparent conductive film 108 on the light receiving substrate 101 of another unit photoelectric cell 103, are electrically connected to each other. In addition, the first transparent conductive film 106 and the second transparent conductive film 108 that correspond to the light receiving substrate 101 of a pair of unit photoelectric cells 103 are separated from those of another pair of unit photoelectric cells 103 by a first scribe line 116.

In the current embodiment, the semiconductor layer 107 of the first unit photoelectric cell 113 and the catalyst layer 109 of the second unit photoelectric cell 114 are formed on the first transparent conductive film 106 of the first unit photoelectric cell 113 and the second transparent conductive film 108 of the second unit photoelectric cell 114, respectively, wherein the first transparent conductive film 106 of the first unit photoelectric cell 113 and the second transparent conductive film 108 of the second unit photoelectric cell 114 are electrically connected to each other.

In addition, transparent conductive films on the counter substrate 102 of two adjacent unit photoelectric cells 103, which are arranged alternately with transparent conductive films on the light receiving substrate 101 of the two adjacent unit photoelectric cells 103, that is, the first transparent conductive film 106 on the counter substrate 102 of one unit photoelectric cell 103 and the second transparent conductive film 108 on the counter substrate 102 of another unit photoelectric cell 103, are electrically connected to each other on the counter substrate 102 disposed facing the light receiving substrate 101 in a perpendicular direction. In addition, the first transparent conductive film 106 and the second transparent conductive film 108 that correspond to the counter substrate 102 of a pair of unit photoelectric cells 103 are separated from those of another pair of unit photoelectric cells 103 by a second scribe line 117.

In the current embodiment, the semiconductor layer 107 of the second unit photoelectric cell 114 and the catalyst layer 109 of the third unit photoelectric cell 115 are formed on the first transparent conductive film 106 of the second unit photoelectric cell 114 and the second transparent conductive film 108 of the third unit photoelectric cell 115, respectively, wherein the first transparent conductive film 106 of the second unit photoelectric cell 114 and the second transparent conductive film 108 of the third unit photoelectric cell 115 are electrically connected to each other.

In the current embodiment, the first scribe lines 116 and the second scribe lines 117 are arranged alternately with each other. Accordingly, electrons of the photoelectric conversion module 100 flow in the order of the second transparent conductive film 108 of one unit photoelectric cell (for example, the first unit photoelectric cell 113) → the catalyst layer 109 of the one unit photoelectric cell → the electrolyte layer 110 of the one unit photoelectric cell → the semiconductor layer 107 of the one unit photoelectric cell → the first transparent conductive film 106 of the one unit photoelectric cell → the second transparent conductive film 108 of an adjacent unit photoelectric cell (for example, the second unit photoelectric cell 114) → the catalyst layer 109 of the other unit photoelectric cell → the electrolyte layer 110 of the other unit photoelectric cell → the semiconductor layer 107 of the other unit photoelectric cell → the first transparent conductive film 106 of the other unit photoelectric cell →...

The electricity generation efficiency of the light receiving substrate 101 on which the light VL, which is shown as an arrow, is incident is higher than that of the counter substrate 102. For example, if the electricity generation efficiency of the light receiving substrate 101 is 100 %, the electricity generation efficiency of the counter substrate 102 is 70 %.

The photovoltaic power generation substantially occurs via the optical electrodes 104 including the semiconductor layers 107. However, the light VL is blocked by the catalyst layers 109 due to a characteristic of a material used to form the catalyst layers 109 and thus light quantity may be significantly decreased. The electricity generation efficiency decreases more since the light also passes through the electrolyte layer 110.

Accordingly, in order to improve the electricity generation efficiency, the size of the semiconductor layers 107 on the light receiving substrate 101 to which the light LV is incident and the size of the semiconductor layers 107 on the counter substrate 102 are formed to be different from each other. More specifically, the width W2 of the semiconductor layers 107 on the counter substrate 102 is greater than a width W1 of the semiconductor layers 107 on the light receiving substrate 101. In alternative embodiments other aspects of the size (e.g. the thickness) of the semiconductor layers could be different.

In this example, the width W2 of the semiconductor layers 107 on the counter substrate 102 is greater than the width W1 of the semiconductor layers 107 on the light receiving substrate 101 but smaller than twice the width W1 of the semiconductor layers 107 on the light receiving substrate 101.

When the width W2 of the semiconductor layers 107 on the counter substrate 102 is greater than twice the width W1 of the semiconductor layers 107 on the light receiving substrate 101, resistance is significantly increased and thus a fill factor may be damaged. Accordingly, power of the photoelectric conversion module 100 is reduced.

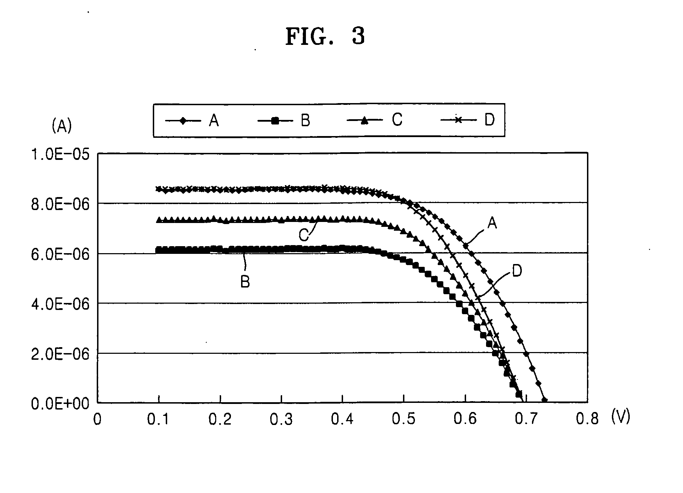

FIG. 3 is a graph showing electricity generation efficiency of the photoelectric conversion module 100 of FIG. 1 measured by varying a width of the semiconductor layers 107 according to an experiment.

Here, an X-axis indicates a voltage V and a Y-axis indicates a current A. Also, a width of the semiconductor layers 107 on the light receiving substrate 101 to which the light LV is incident is 5 mm (A), and a width of the semiconductor layers 107 on the counter substrate 102 is 5 mm (B), 6 mm (C), and 7 mm (D) for three different tests, respectively.

Referring to FIG. 3, as the width of the semiconductor layers 107 on the counter substrate 102 increases from 5 mm (B) to 7 mm (D), a current value increases and thus the current value of the counter substrate 102 may be approximately be the same as the current value of the light receiving substrate 101. That is, if the width of the semiconductor layers 107 on the counter substrate 102 is greater by 40 % the width of the semiconductor layers 107 on the light receiving substrate 101, an optimum current value may be obtained.

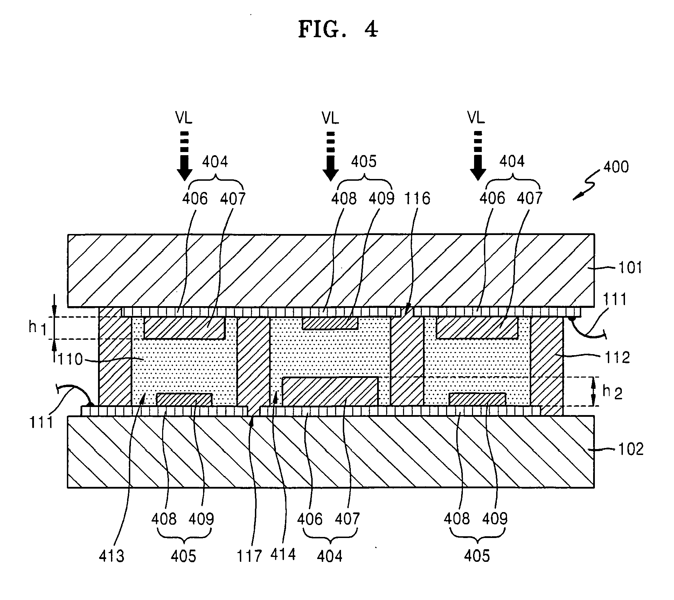

FIG. 4 is a cross-sectional view of a photoelectric conversion module 400 according to another embodiment of the present invention.

Like reference numerals in the drawings described above denote like elements. A thickness of semiconductor layers 407 vary in the photoelectric conversion module 400, whereas the widths of the semiconductor layers 107 vary in the photoelectric conversion module 100 of FIG. 1.

Referring to FIG. 4, optical electrodes 404 and counter electrodes 405 are alternately arranged on the light receiving substrate 101. The counter electrodes 405 and the optical electrodes 404 are alternately arranged on the counter substrate 102. The counter electrodes 405 and the optical electrodes 404 alternately arranged on the counter substrate 102 face the optical electrodes 404 and the counter electrodes 405 alternately arranged on the light receiving substrate 101, respectively.

Also, one semiconductor layer 407 on the light receiving substrate 101 of one unit photoelectric cell 403 and one catalyst layer 409 on the light receiving substrate 101 of an adjacent unit photoelectric cell 403 are formed on a first transparent conductive film 406 on the light receiving substrate 101 of the one unit photoelectric cell 403 and a second transparent conductive film 408 on the light receiving substrate 101 of the other unit photoelectric cell 403, respectively, wherein the first transparent conductive film 406 on the light receiving substrate 101 of the one unit photoelectric cell 403 and the second transparent conductive film 408 on the light receiving substrate 101 of the other unit photoelectric cell 403 are electrically connected to each other. On the counter substrate 102 disposed facing the light receiving substrate 101 in a perpendicular direction, one semiconductor layer 407 on the counter substrate 102 of one unit photoelectric cell 403 and one catalyst layer 409 on the counter substrate 102 of another unit photoelectric cell 403, which are respectively arranged alternately with the catalyst layer 409 on the light receiving substrate 101 of the one unit photoelectric cell 403 and the semiconductor layer 407 on the light receiving substrate 101 of the other unit photoelectric cell 403, are formed on one first transparent conductive film 406 on the counter substrate 102 of the one unit photoelectric cell 403 and one second transparent conductive film 408 on the counter substrate 102 of the other unit photoelectric ceii 403, respectively, wherein the first transparent conductive film 406 on the counter substrate 102 of the one unit photoelectric cell 403 and the second transparent conductive film 408 on the counter substrate 102 of the other unit photoelectric cell 403 are electrically connected to each other.

Again, the size of the semiconductor layers 407 on the light receiving substrate 101 to which light is incident and the size of the semiconductor layers 407 on the counter substrate 102 on the counter substrate 102 are formed to be different with respect to each other. More specifically, the height h2 of the semiconductor layers 407 on the counter substrate 102 is greater than the height h1 of the semiconductor layers 407 on the light receiving substrate 101.

For example, if widths of the semiconductor layers 407 are the same with respect to the light receiving substrate 101 as with respect to the counter substrate 102, the height h1 of the semiconductor layers 407 on the light receiving substrate 101 is about 8 through 25 µm, for example, about 13 through 15 µm.

On the other hand, the height h2 of the semiconductor layers 407 on the counter substrate 102 may be greater than the height h1 of the semiconductor layers 407 on the light receiving substrate 101 but may be less than or equal to a maximum height, for example, ±5 µm, of the semiconductor layers 407 on the light receiving substrate 101. Then, the electricity generation efficiency of the photoelectric conversion module 400 may be improved.

The size of the semiconductor layers 407 on the counter substrate 102 with respect to the size of the semiconductor layers 407 on the light receiving substrate 101 is not limited to being varied with respect to only a width or a thickness and instead the thickness and the width of the semiconductor layers 407 may be varied to form semiconductor layers that are asymmetric with each other on the light receiving substrate 101 and the counter substrate 102.

As described above, according to the one or more of the above embodiments of the present invention, the size of optical electrodes each including a semiconductor layer are formed to be different from each other in a photoelectric conversion module and thus the electricity generation efficiency may be improved.

It should be understood that the embodiments described therein should be considered in a descriptive sense only and not for purposes of limitation. Descriptions of features or aspects within each embodiment should typically be considered as available for other similar features or aspects in other embodiments.

## Claims

1. A photoelectric conversion device comprising:
a first substrate;
a second substrate opposing the first substrate;
a first photoelectric cell located between the first and second substrates and containing electrolyte, the first photoelectric cell including a first optical electrode over the first substrate and a first counter electrode over the second substrate, the first optical electrode comprising a first semiconductor layer;
a second photoelectric cell located between the first and second substrates and containing electrolyte, the second photoelectric cell being adjacent the first photoelectric cell and including a second optical electrode over the second substrate and a second counter electrode over the first substrate, the second optical electrode comprising a second semiconductor layer;
wherein the size of the second semiconductor layer is larger than that of the first semiconductor layer.

2. A photoelectric conversion device according to claim 1, wherein the second semiconductor layer has a width that is greater than the first semiconductor layer.

3. A photoelectric conversion device according to claim 1 or 2, wherein the wherein the second semiconductor layer has a height that is greater than the first semiconductor layer.

4. A photoelectric conversion device according to any preceding claim, wherein the second semiconductor layer contains more semiconductor material than the first semiconductor layer.

5. A photoelectric conversion device according to any preceding claim, wherein:
the first optical electrode further comprises a first conductive film disposed between the first semiconductor layer and the first substrate; and
the first counter electrode includes a second conductive film over the second substrate and a first catalyst layer over of the second conductive film.

6. A photoelectric conversion device according to claim 5, wherein:
the second counter electrode includes a third conductive film over the first substrate and a second catalyst layer over the third conductive film; and
the second optical electrode further comprises a fourth conductive film disposed between the second semiconductor layer and the second substrate;
optionally wherein the first conductive film and the third conductive film are integrally formed as one film extending from the first photoelectric cell to the second photoelectric cell.

7. A photoelectric conversion device according to claim 6, wherein the second conductive film is separated from the fourth conductive film by a first scribe line.

8. A photoelectric conversion device according to any preceding claim, further comprising a first sealant separating the first photoelectric cell and the second photoelectric cell.

9. A photoelectric conversion device according to 8 when dependent on claim 7, wherein the first scribe line is located in the region of the first sealant.

10. A photoelectric conversion device according to any preceding claim, further comprising a third photoelectric cell adjacent the second photoelectric cell, the third photoelectric cell including a third optical electrode over the first substrate and a third counter electrode over the second substrate, the third optical electrode comprising a third semiconductor layer, wherein the second semiconductor layer is larger than the third semiconductor layer.

11. A photoelectric conversion device according to claim 10, wherein:
the third optical electrode further comprises a fifth conductive film disposed between the third semiconductor layer and the first substrate;
the third counter electrode includes a sixth conductive film over the second substrate and a third catalyst layer over of the sixth conductive film; and
optionally wherein the fourth conductive film and the sixth conductive film are integrally formed as one film extending from the second photoelectric cell to the third photoelectric cell.

12. A photoelectric conversion device according to claim 11 when dependent on any claim dependent on claim 6, wherein the third conductive film is separated from the fifth conductive film by a second scribe line.

13. A photoelectric conversion device according to any one of claims 10 to 12, further comprising a second sealant separating the second photoelectric cell and the third photoelectric cell.

14. A photoelectric conversion device according to 13 when dependent on claim 12, wherein the second scribe line is located in the region of the second sealant.

15. A photoelectric conversion module of Claim 1,
wherein the first optical electrode of the first photoelectric cell and second counter electrode of the second photoelectric cell are alternately arranged on the first substrate, wherein the first counter electrode of the first photoelectric cell and the second optical electrode of the second photoelectric cell are alternately arranged on the second substrate,
wherein the first optical electrode comprises a first conductive film, wherein the first counter electrode comprises a second conductive film, wherein the second counter electrode comprises a third conductive film, and, the second optical electrode comprises a fourth conductive film,
wherein the first conductive film and the third conductive film are electrically connected to each other on the first substrate, and wherein the first conductive film and the third conductive film are separated from each other by a first scribe line between a pair of the first and the second photoelectric cells and another adjacent pair of the first and the second unit photoelectric cells,
wherein the second conductive film and the fourth conductive film are electrically connected to each other on the second substrate to respectively alternate with the first conductive film and the third conductive film, and the second conductive film and the fourth conductive film are separated from each other by a second scribe line between the pair of the first and the second photoelectric cells and the another adjacent pair of the first and the second photoelectric cells.
